# EUROPEAN PATENT SPECIFICATION

(11) **EP 1 806 424 B1**
(45) Date of publication and mention of the grant of the patent: **13.05.2009**
(21) Application number: 06126830.6
(22) Date of filing: 21.12.2006
(51) Int. Cl.: C23C 14/30

(54) **Physical vapor deposition process and apparatus therefor**
Verfahren und Vorrichtung zur physikalischen Dampfabscheidung
Procédé et dispositif de dépôt physique en phase vapeur

(30) Priority: 10.01.2006 US 306740
(43) Date of publication of application: 11.07.2007
(73) Proprietor: GENERAL ELECTRIC COMPANY, Schenectady, NY 12345 (US)
(72) Inventor: Marijnissen, Gillion Herman, 5896 NC, Beringe (NL); Vergeldt, Eric Richard Irma Carolus, 5941 AE, Velden (NL); Rigney, Joseph David, Milford, OH 45150 (US); Kloosterman, Annejan Bernard, 7943 RH, Meppel (NL); Darolia, Ramgopal, West Chester, OH 45069 (US)
(74) Representative: Bedford, Grant Richard

(56) References cited:
- EP-A- 1 008 669
- EP-A- 1 445 344
- US-A1- 6 054 184

## Description

The present invention generally relates to coating processes and apparatuses. More particularly, this invention relates to a physical vapor deposition (PVD) apparatus and process for depositing a coating whose composition contains one or more reactive metals, such as a nickel aluminide alloyed with zirconium, hafnium, yttrium, and/or lanthanum.

In addition to high temperatures that can decrease their mechanical properties, components within the turbine, combustor, and augmentor sections of gas turbine engines are susceptible to oxidation and hot corrosion attack. Consequently, these components are often protected by an environmental coating alone or in combination with a ceramic thermal barrier coating (TBC), which in the latter case the environmental coating is termed a bond coat for the TBC. Components protected by an environmental coating or TBC system exhibit greater durability as well as afford the opportunity to improve engine efficiency by increasing the operating temperature of a gas turbine engine.

Environmental coatings and TBC bond coats are often formed of an oxidation-resistant aluminum-containing alloy or intermetallic whose aluminum content provides for the slow growth of a stable, adherent, and slow-growing aluminum oxide (alumina) layer (or scale) at elevated temperatures. Notable examples include diffusion coatings that contain aluminum intermetallics, predominantly beta-phase nickel aluminide and platinum-modified nickel aluminides (PtAl), and overlay coatings such as MCrAlX alloys (where M is iron, cobalt and/or nickel, and X is an active element such as yttrium or another rare earth or reactive element) or aluminide intermetallics (e.g., beta-phase and gamma-phase nickel aluminides). As examples of the latter, commonly-assigned U.S. Patent Nos. 5,975,852, 6,291,084, 6,153,313, and 6,255,001 disclose beta-NiAl materials that are either optionally or preferentially alloyed to contain chromium and one or more active elements, such as yttrium, zirconium, hafnium, and/or lanthanum. The alumina scale grown by these coatings protects the coatings and their underlying substrates from oxidation and hot corrosion and promotes chemical bonding of a TBC (if present).

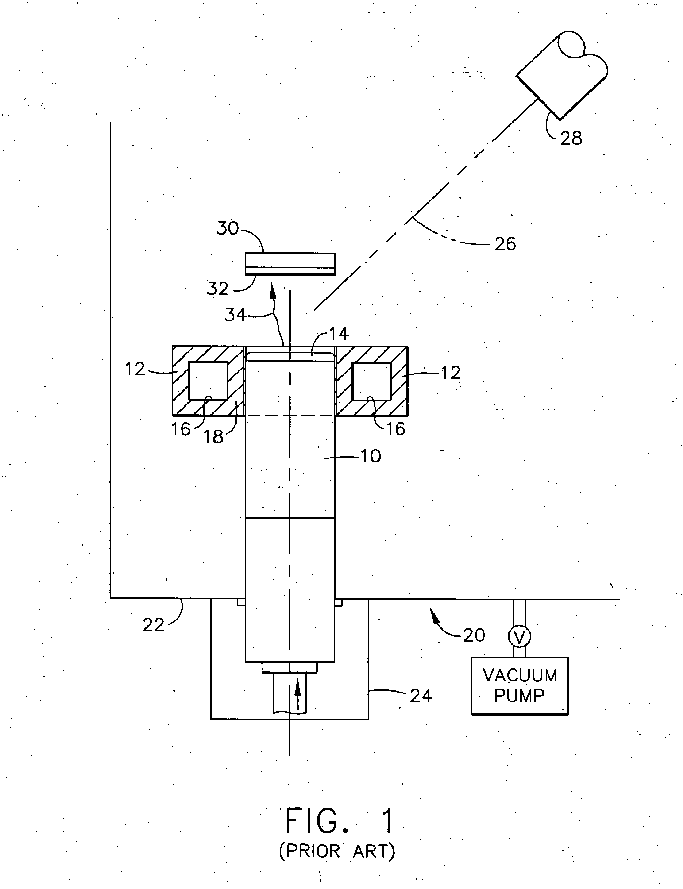

Suitable processes for depositing aluminide intermetallic and MCrAIX overlay coatings include thermal spraying such as plasma spraying and high velocity oxyfuel (HVOF) processes, and physical vapor deposition (PVD) processes such as electron beam physical vapor deposition (EBPVD), magnetron sputtering, cathodic arc, ion plasma, and pulsed laser deposition (PLD). PVD processes require the presence of a coating source material made essentially of the coating composition desired, and means for creating a vapor of the coating source material in the presence of a substrate that will accept the coating. Figure 1 schematically represents a portion of an EBPVD coating apparatus 20, including a coating chamber 22 in which a component 30 is suspended for coating. An overlay coating 32 is represented as being deposited on the component 30 by melting and vaporizing an ingot 10 of the desired coating material with an electron beam 26 generated by an electron beam (EB) gun 28. The intensity of the beam 26 is sufficient to product a stream 34 of vapor that condenses on the component 30 to form the overlay coating 32. As shown, the vapor stream 34 evaporates from a pool 14 of molten coating material contained within a reservoir formed by a crucible 12 that surrounds the upper end of the ingot 10. Water or another suitable cooling medium flows through cooling passages 16 defined within the crucible 12 to maintain the crucible 12 at an acceptable temperature. As it is gradually consumed by the deposition process, the ingot 10 is incrementally fed into the chamber 22 through an airlock 24.

The addition of limited amounts of reactive metals to overlay aluminide and MCrAIX materials has been shown to significantly improve properties such as high temperature strength and TBC adhesion, thereby increasing the overall service lives of these protective coating systems and the components they protect. For example, as reported in commonly-assigned U.S. Patent No. 6,869,508, beta-NiAl overlay coatings benefit from very limited additions of zirconium, hafnium, yttrium, and/or cerium. However, difficulties have been encountered when attempting to co-deposit these reactive elements with the other elements of aluminide and MCrAlX overlay coatings, particularly when attempting to deposit these coatings by EBPVD. Such difficulties have been attributed to the significantly different vapor pressures that these metals have compared to the other coating elements, leading to limited deposition rates and difficulties in achieving controlled chemistries for the coatings. One approach to addressing this difficulty is to add a relatively large amount of the desired reactive element or elements to the main evaporation pool 14 by appropriately forming the ingot 10 to contain the principal elements of the coating (e.g., nickel, aluminum, chromium, etc.) and an amount of the reactive element(s) that exceeds the amount intended for the coating. However, if the vapor pressure of the reactive element is sufficiently low compared to the principal elements (as is the case with zirconium), at best the rate of evaporation is very low to the extent that an economical deposition process is difficult to achieve. A second approach is to evaporate the reactive element from a separate pool formed by simultaneously melting a second ingot formed of the reactive element. This approach is complicated by the instability of molten pools of reactive elements when attempting to deposit at the low rates desired for aluminide and MCrAIX overlay coatings.

In view of the above, it would be desirable if an improved evaporation process existed that was suitable for forming overlay environmental coatings and bond coats and was capable of co-depositing small, controlled amounts of reactive elements.

According to various aspects, the present invention provides a PVD process for depositing a coating from multiple sources of different materials. The process is particularly well suited for depositing aluminide and MCrAIX overlay coatings alloyed to contain one or more reactive metals whose vapor pressures are significantly lower than other elements of the coating.

The process of this aspect of the invention entails forming at least first and second molten pools of different first and second materials, respectively, in a coating chamber of a PVD apparatus, supporting an article within the coating chamber, and evaporating the first and second molten pools with an energy beam to deposit a coating on the article with a controlled composition that contains at least a first metal and a relatively lesser amount of at least one reactive metal having a lower vapor pressure than the first metal. The first material contains at least the first metal, and the second material contains at least a second metal and the reactive metal. The process further entails combining the second metal with the reactive metal to cause the second material to have a melting temperature less than the melting temperature of the reactive metal and to have a wider melting range than the reactive metal.

A PVD apparatus suitable for carrying out the invention includes a coating chamber that contains at least first and second molten pools of different first and second materials, respectively, an article supporter within the coating chamber, and means for evaporating the first and second molten pools to deposit a coating on the article. The first material contains at least a first metal, and the second material contains at least a second metal and at least one reactive metal having a lower vapor pressure than the first metal of the first material. The second metal is combined with the reactive metal to cause the second material to have a melting temperature less than the melting temperature of the reactive metal and to have a wider melting range than the reactive metal. The evaporating means is operable to evaporate the first and second molten pools so that the coating deposited on the article has a controlled composition that contains the first metal and a relatively lesser amount of the reactive metal.

A PVD apparatus suitable for carrying out the invention is disclosed in EP-A-1445344.

According to various aspects of the invention, combining the low vapor pressure reactive metal with the second metal as set forth above improves the stability of the molten pool containing the reactive element, enabling the reactive metal to be deposited in small, more controllable amounts than if attempting to melt and evaporate a molten pool containing only the reactive element. The improved stability and evaporation rate are believed to arise in part as a result of the second metal reducing the melting temperature of the second metal compared to the reactive metal, such as through a eutectic, isomorphous, etc., reaction with the reactive metal, and also in part as a result of the second metal increasing the temperature range over which the reactive metal is available in molten form for evaporation ,and deposition. The second metal can be chosen to have a sufficiently lower vapor pressure than the reactive element to minimize and potentially avoid the deposition of the second metal on the article being coated: Alternatively, the second metal can be chosen to have a vapor pressure that results in the second metal being co-deposited with the first and reactive metals to improve the properties of the resulting coating.

Other objects and advantages of this invention will be better appreciated from the following detailed description and drawings, in which:
Figure 1 shows a schematic representation of a portion of a prior art EBPVD apparatus.
Figure 2 is a schematic representation of a portion of an EBPVD apparatus suitable for carrying out deposition processes in according with various embodiments of this invention.
Figure 3 is schematic representations of a portion of an EBPVD apparatus according to an alternative embodiment of this invention.

Various aspects and embodiments of the present invention are generally applicable to depositing protective coatings on components that operate within environments characterized by high temperatures, such as the turbine, combustor, and augmentor sections of gas turbine engines, and are therefore subjected to oxidation and hot corrosion. However, as will become evident from the following discussion, aspects of the invention are applicable to a variety of other coating types and compositions.

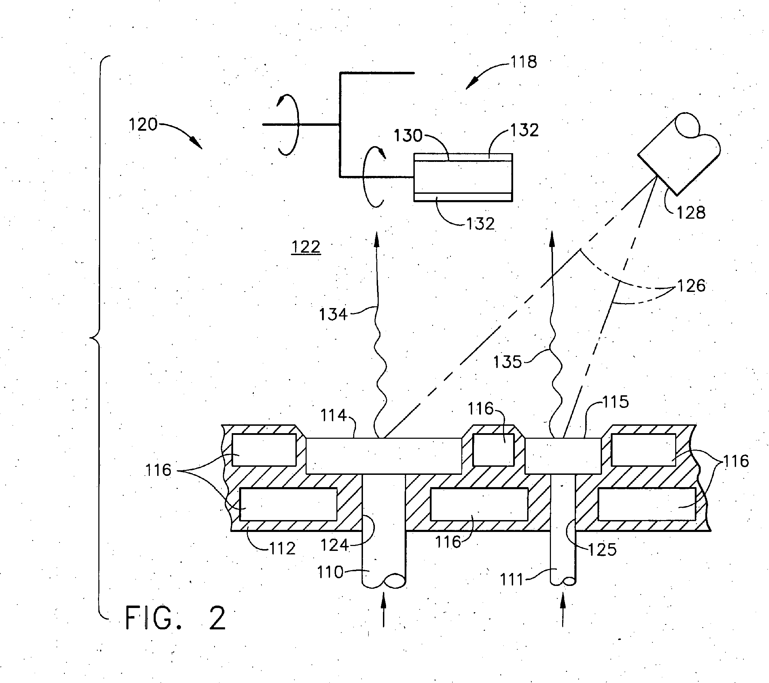

A coating apparatus 120 is represented in Figure 2 as being similar to the apparatus 20 of Figure 1, and representative of a type suitable for depositing metallic overlay coatings, such as but not limited to MCrAlX and aluminide coatings used as environmental coatings and bond coats for TBC's. The apparatus 120 is shown as comprising a crucible 112 through which a pair of ingots 110 and 111 are fed into a coating chamber 122, and an electron beam (EB) gun 128 generates an electron beam 126 that, through the use of a suitable controlled beam jumping technique, is able to melt the upper surfaces of both ingots 110 and 111 to produce separate molten pools 114 and 115 of the ingot materials within the crucible 112. With such a technique, the beam 126 is briefly projected (in the millisecond range) on each ingot 110 and 111, with the amount of time on each ingot 110 and 111 being adjusted so that the energy output maintains both pools 114 and 115 in molten states. As an alternative to the use of the single EB gun 128 shown in Figure 2, it is within the scope of this invention to use two or more EB guns to produce separate electron beams that form and maintain the molten pools 114 and 115. It is also within the scope of this invention that the deposition process could make use of more than two molten pools.

As with the apparatus 20 of Figure 1, a component 130 is supported within the coating chamber 122 so that an overlay coating 132 is deposited on the component 130 as a result of the evaporation of material from the molten pools 114 and 115, which produces streams 134 and 135 of vapors that condense on the component 130. The component 130 is represented as supported on planetary tooling 118 that supports the component 130 over both pools 114 and 115, so that the overlay coating 132 is a mixture of the ingot materials. As they are gradually consumed by the deposition process, the ingots 110 and 111 are incrementally fed into the chamber 122 through separate passages 124 and 125 in the crucible 112. As known in the art, water or another suitable cooling medium preferably flows through cooling passages 116 defined within the crucible 112 to maintain the crucible 112 at an acceptable temperature. Those skilled in the art will appreciate that, beyond the desire to simultaneously deposit material from both ingots 110 and 111, the type of support tooling and crucible used and the shape and size of the material being evaporated are not of particular importance to the invention. However, it should be noted that increasing the size and number of the molten pools 114 and 115 advantageously increases the size of the coating zone within the chamber 122. Because the chemistry of the vapor cloud resulting from the vapor streams 134 and 135 will likely vary from one location to another within the cloud, the use of the planetary tooling 118 or an equivalent is desirable if multiple components or surfaces are to be coated in a single operation. Finally, it is also worth noting that energy beams of than the electron beams 126, e.g., laser beams, could be employed to evaporate the ingots 110 and 111, and the power level(s) of such beam(s) can be controlled to modify and optimize evaporation rates and the resulting chemistry for the coating 132.

From the above, it can be appreciated that the overlay coating 132 will contain elements from both of the ingots 110 and 111. For example, if the desired overlay coating 132 is a beta-NiAl intermetallic material , the ingots 110 and 111 provide in combination nickel, aluminum, and any additional desired alloying constituents, such as chromium, one or more reactive elements, etc., to yield a coating useful as an environmental coating or bond coat for gas turbine engine applications. As taught in commonly-assigned U.S. Patent Nos. 5,975,852 to Nagaraj et al., 6,153,313 to Rigney et al., 6,255,001 to Darolia, 6,291,084 to Darolia et al., 6,620,524 to Pfaendtner et al., and 6,682,827 to Darolia et al., particularly suitable NiAl-based coatings contain about 20 to 32 weight percent (about 35-50 atomic percent) aluminum to achieve the beta intermetallic phase, and may contain one or more of chromium, titanium, tantalum, silicon, gallium, calcium, and iron, and one or more reactive metals such as zirconium, hafnium, cerium, yttrium, and/or lanthanum. The presence of limited amounts of reactive metals in beta-NiAl overlay coatings, typically not exceeding about two weight percent of such coatings and preferably about one weight percent, has been shown to improve environmental resistance and strength, the latter primarily by solid solution strengthening of the beta-phase NiAl matrix.

Zirconium, hafnium, yttrium, and lanthanum have sufficiently lower vapor pressures than beta-NiAl to lead to limited deposition rates and difficulties in achieving controlled coating chemistries. During evaporation of these reactive metals from a separate pool (e.g., 115), the vapor pressure above the melting point of the reactive metal is still very low compared to NiAl. Furthermore, evaporating a superheated molten pool 115 containing a single (pure) reactive element can lead to pool instability. Because pool stability is important to maintain constant evaporation for control of coating composition, if the pool 115 were to be formed of a single reactive metal, care must be taken to maintain the pool 115 above the high melting temperature of the reactive metal.

With the embodiment of Figure 2, reactive constituents with relatively low vapor pressures (such as zirconium, hafnium, yttrium, and lanthanum) compared to the remaining coating constituents (e.g., nickel, aluminum, chromium, etc.) are provided in one of the ingots (e.g., 111), while the principal constituents of the coating 132, such as beta-NiAl and chromium (if present), are present in the other ingot (e.g., 110). The electron beam 126 is then generated to melt and vaporize the ingots 110 and 111 to produce stable molten pools 114 and 115 from which the coating constituents can be evaporated at controlled rates to produce the coating 132 with a predictable chemistry. According to the embodiment of Figure 2, the composition of the ingot 111 containing the one or more low vapor pressure reactive metals is alloyed to contain at least a second metal that, through a eutectic, isomorphous, etc., reaction with the reactive metal(s), results in the material of the ingot 111 having a lower melting temperature and a wider melting temperature range than the reactive metal(s), so that the stability of the molten pool 115 is significantly increased and the uniformity of the coating chemistry is improved.

As an example of the above, zirconium can be alloyed with tungsten to form a eutectic (about 91.0 atomic percent zirconium) whose melting temperature (about 1735°C) is significantly lower than the melting temperature of zirconium (about 1855°C). Furthermore, tungsten can be alloyed with zirconium over a range of above 88 to less than 100 atomic percent zirconium to form alloys with lower melting temperatures than zirconium (covering a melting range of about 120°C). As such, a Zr-W alloy having a tungsten content approaching 12 atomic percent benefits the evaporation of zirconium by reducing the temperature required to maintain the molten pool 115 and increasing the temperature range over which the pool 115 is molten and stable. Because tungsten has a vapor pressure lower than zirconium, the deposition process can be carried out so that little if any tungsten is co-deposited with zirconium on the component 130. For example, the EB gun 128 can be operated to control the temperature of the molten pool 115, with lower temperatures promoting the deposition of the higher vapor pressure metal (e.g., zirconium) with little if any co-deposition of the lower vapor pressure metal (e.g., tungsten), whereas higher pool temperatures promote co-deposition of the lower and higher vapor pressure metals.

Other metals with lower vapor pressures than zirconium and capable of providing a similar benefit include tantalum and rhenium. As such, any one or more of tungsten, tantalum, and rhenium can be alloyed with zirconium to reduce the melting temperature of the ingot 111 and increase the temperature range over which the pool 115 is molten and stable, with or without being co-deposited with zirconium. In addition, tantalum and/or rhenium combined with zirconium have the additional advantage of improving the properties (strength, adhesion, etc.) of the coating 132.

A similar benefit can be achieved with, for example, hafnium as the desired reactive metal. For example, hafnium can be alloyed with zirconium and/or tantalum (whose vapor pressures are lower than hafnium) to yield a material with a melting temperature lower than hafnium and having a relatively wide temperature range over which the pool 115 is molten and stable, with or without being co-deposited with hafnium. Notably, the co-deposition of hafnium with either or both zirconium and tantalum has the advantage of improving the properties (strength, adhesion, etc.) of the coating 132.

Alternatively, the reactive element can be alloyed with a metal having a higher vapor pressure. As an example, any additions of yttrium to zirconium will yield a Zr-Y alloy having a lower melting temperature than zirconium, with a minimum melting temperature of about 1353°C corresponding to an yttrium content of about 40 atomic percent. As such, a Zr-Y alloy benefits the evaporation of zirconium by reducing the temperature required to maintain the molten pool 115 and by increasing the temperature range over which the pool 115 is molten and stable. Because yttrium has a higher vapor pressure than zirconium, the deposition process inherently co-deposits yttrium and zirconium on the component 130, with the relative amounts of yttrium and zirconium being controllable over a wide range by the relative amounts of yttrium and zirconium in the ingot 111.

In view of the above, various aspects of the present invention enable the use of lower temperatures to maintain the molten pool 115 containing one or more reactive elements, resulting in more stable evaporation. In this way, small amounts of the desired reactive metal in the pool 115 can be deposited in the overlay coating 132 in a more controllable way. By using one or more additional (alloying) metals with lower vapor pressures compared to the vapor pressure of the desired reactive metal, co-deposition of one or more of the alloying metals can be minimized (e.g., at levels of about five weight percent or less, more preferably less than 0.05 weight percent) or even avoided. Alternatively, properties of the coating 132 can be modified and potentially improved by intentionally co-depositing one or more alloying metals with the reactive metal. In this case, the combination of metals is still intended to produce a molten pool 115 that exists over a range of temperatures, but the alloying metal or metals can either have higher, the same, or lower vapor pressures than the desired reactive metal(s), depending on the chemistry desired for the coating 132.

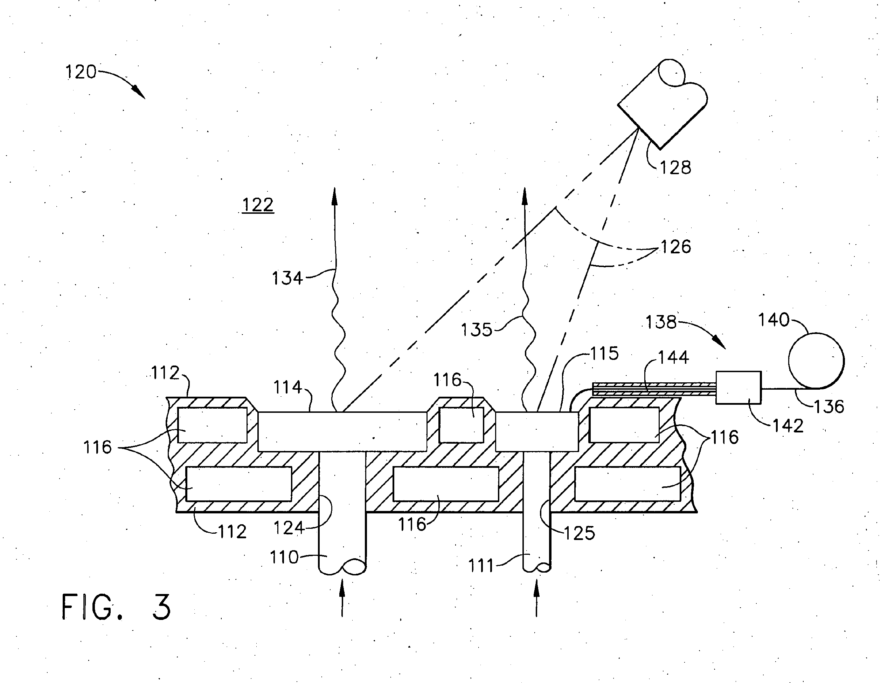

Also within the scope of this invention is to form a low melting alloy in situ by feeding the reactive metal or metals separately into the molten pool 115, as represented in Figure 3. In this embodiment, rather than the ingot 111 being formed of an alloy of the reactive metal and the second metal intended to alloy with the reactive metal, the ingot 111 may be formed entirely of the second metal while the reactive metal is fed separately to alloy with the second metal as it becomes melted. Alternatively, the ingot 111 may be formed entirely of the reactive metal or as a mixture of the reactive and second metals, with an additional amount of the second metal being fed separately to form in situ a suitable alloy in the molten pool 115. With either approach, this embodiment has the advantage of avoiding the potential for the lower vapor pressure metal (e.g., tungsten) accumulating over time if the higher vapor pressure metal (e.g., zirconium) is preferentially evaporated, and therefore is able to selectively control the composition of the vapor stream 135 and compensate for material lost to evaporation. In Figure 3, the crucible 112 is modified to feed a wire 136 of, for example, the lower vapor pressure material into the chamber 122, instead of the ingot 111. The wire 136 is shown as being dispensed with a feed system 138 that includes a spool 140 from which the wire 136 is pulled by a wire feed device 142, which feeds the wire 136 through a guide 144 to the molten pool 115. Alternatively, the wire 136 could be fed by the wire feed device 142 through a passage defined within the upper surface of the crucible 112. Other than appropriately modifying the control of the EB gun 128 to achieve a desired evaporation rate, the embodiment of Figure 3 is similar to that of Figure 2. An advantage of feeding a smaller diameter wire is the capability of a more accurate measurement of the feed rate of the reactive metal.

In an investigation leading to this invention, a multi-pool EBPVD evaporation process was conducted for the purpose of depositing a beta-NiAl overlay coating containing zirconium as a reactive metal additive. In a first trial series, nickel and aluminum were evaporated from a first molten pool, and unalloyed zirconium was evaporated from a separate molten pool. The molten zirconium pool proved to be unstable and the resulting coatings contained significantly varying zirconium percentages. In a second trial series, zirconium was alloyed with about 10 atomic percent tungsten, and the EB-PVD evaporation process was repeated. The Zr-W pool was molten at a lower temperature and more stable than the zirconium pool of the previous trial, and the zirconium content of the deposited coatings was much more consistent. As seen from the test results of these trials summarized in Table I below, the standard deviation for the zirconium content of the coatings from the second trial was reduced by a factor of about four compared to the coatings of the first trial.

| | Zr Pool | Zr-W Pool |
|---|---|---|
| Average Zr Content in the Coatings: | 1.01 at.% | 0.64 at.% |
| Standard Deviation of Zr Content: | 0.59 at.% | 0.14 at.% |
| Number of Coating Samples: | 802 | 48 |

Though the above results were obtained with beta-NiAl coatings deposited by EBPVD, it is believed that similar results can also be achieved by depositing other coating compositions and using other PVD processes. Therefore, while the invention has been described in terms of particular embodiments, it is apparent that modifications could be adopted by one skilled in the art. Accordingly, the scope of the invention is to be limited only by the following claims.

### PART LIST

- 10: Ingot
- 12: Crucible
- 16: Passages
- 18: Tooling
- 20: Apparatus
- 22: Chamber
- 24: Air Lock
- 26: Beam
- 28: Gun
- 30: Component
- 32: Coating
- 34: Vapor Stream

- 110: Ingot
- 111: Ingot
- 112: Crucible
- 114: Pool
- 115: Pool
- 116: Passages
- 118: Tooling
- 120: Apparatus
- 122: Chamber
- 124: Paseages
- 125: Passages
- 126: Beam
- 128: Gun
- 130: Component
- 132: Coating
- 134: Vapor Stream
- 135: Vapor Stream

## Claims

1. A physical vapor deposition process comprising the steps of:
forming at least first and second molten pools (114,115) of different first and second materials, respectively, in a coating chamber (122) of a physical vapor deposition apparatus (120), the first material containing at least a first metal, the second material containing at least a second metal and at least one reactive metal having a lower vapor pressure than the first metal of the first material, the second metal being combined with the reactive metal to cause the second material to have a melting temperature less than the melting temperature of the reactive metal and to have a wider melting range than the reactive metal;
supporting an article (130) within the coating chamber (122); and
evaporating the first and second molten pools (114,115) with an energy beam (126) to deposit a coating (132) on the article (130) with a controlled composition that contains the first metal and a relatively lesser amount of the reactive metal.

2. The physical vapor deposition process according to claim 1, **characterized in that** the second metal is co-deposited with the first metal and the reactive metal and the coating (132) on the article (130) contains the first and second metals and the reactive metal.

3. The physical vapor deposition process according to claim 1, **characterized in that** the second metal is not co-deposited with the first metal and the reactive metal and the coating (132) on the article (130) contains the first metal and the reactive metal but is substantially free of the second metal.

4. The physical vapor deposition process according to any one of claims 1 through 3, **characterized in that** the second metal and the reactive metal are combined as an alloy in the form of a solid body (111) that is delivered to the coating chamber (122) and melted with the energy beam (126) to form the second molten pool (115).

5. The physical vapor deposition process according to any one of claims 1 through 3, **characterized in that** the second metal and the reactive metal are delivered to the coating chamber (122) as separate solid bodies (115,136) that are melted with the energy beam (126) to combine and form the second molten pool (115).

6. The physical vapor deposition process according to any one of claims 1 through 5, **characterized in that** the first material is a beta-NiAl intermetallic.

7. The physical vapor deposition process according to any one of claims 1 through 6, **characterized in that** the reactive element is at least one element chosen from the group consisting of zirconium, hafnium, yttrium, and lanthanum.

8. The physical vapor deposition process according to any one of claims 1 through 7, **characterized in that** the second metal has a lower vapor pressure than the reactive element.

9. The physical vapor deposition process according to any one of claims 1 through 7, **characterized in that** the second metal has a higher vapor pressure than the reactive element.

## Patentansprüche

1. Verfahren zur physikalischen Dampfabscheidung mit den Schritten:
Erzeugen wenigstens eines ersten und eines zweiten Schmelzbades (114, 115) aus unterschiedlichen ersten bzw. zweiten Materialien in einer Beschichtungskammer (122) einer Vorrichtung (120) für physikalische Dampfabscheidung, wobei das erste Material wenigstens ein erstes Metall enthält, das zweite Material wenigstens ein zweites Metall und wenigstens ein reaktives Metall mit einem niedrigeren Dampfdruck als das erste Metall des ersten Materials enthält, wobei das zweite Metall mit dem reaktiven Metall kombiniert ist, um zu bewirken, dass das zweite Material eine niedrigere Schmelztemperatur als die Schmelztemperatur des reaktiven Metalls und einen breiteren Schmelzbereich als das reaktive Metall hat;
Lagern eines Gegenstandes (130) in der Beschichtungskammer (122); und
Verdampfen der ersten und zweiten Schmelzbäder (114, 115) mit einem Energiestrahl (126), um auf dem Gegenstand (130) eine Beschichtung (132) mit einer gesteuerten Zusammensetzung abzuscheiden, die das erste Metall und eine relativ geringere Menge des reaktiven Metalls enthält.

2. Verfahren zur physikalischen Dampfabscheidung nach Anspruch 1, **dadurch gekennzeichnet, dass** das zweite Metall zusammen mit dem ersten Metall und dem reaktiven Metall abgeschieden wird und die Beschichtung (132) auf dem Gegenstand (130) die ersten und zweiten Metalle und das reaktive Metall enthält.

3. Verfahren zur physikalischen Dampfabscheidung nach Anspruch 1, **dadurch gekennzeichnet, dass** das zweite Metall nicht zusammen mit dem ersten Metall und dem reaktiven Metall abgeschieden wird und die Beschichtung (132) auf dem Gegenstand (130) das erste Metall und das reaktive Metall enthält, aber im Wesentlichen frei von dem zweiten Metall ist.

4. Verfahren zur physikalischen Dampfabscheidung nach einem der Ansprüche 1 bis 3, **dadurch gekennzeichnet, dass** das zweite Metall und das reaktive Metall als eine Legierung in der Form eines festen Körpers (111) kombiniert sind, der der Beschichtungskammer (112) zugeführt und mit dem Energiestrahl (126) geschmolzen wird, um das zweite Schmelzbad (115) zu erzeugen.

5. Verfahren zur physikalischen Dampfabscheidung nach einem der Ansprüche 1 bis 3, **dadurch gekennzeichnet, dass** das zweite Metall und das reaktive Metall der Beschichtungskammer (122) als getrennte feste Körper (115, 136) zugeführt werden, die mit dem Energiestrahl (126) geschmolzen werden, um das zweite Schmelzbad (115) zu kombinieren und auszubilden.

6. Verfahren zur physikalischen Dampfabscheidung nach einem der Ansprüche 1 bis 5, **dadurch gekennzeichnet, dass** das erste Material ein Beta-NiAl-Intermetall ist.

7. Verfahren zur physikalischen Dampfabscheidung nach einem der Ansprüche 1 bis 6, **dadurch gekennzeichnet, dass** das reaktive Element wenigstens ein aus der aus Zirkonium, Hafnium, Yttrium und Lanthan bestehenden Gruppe ausgewähltes Element ist.

8. Verfahren zur physikalischen Dampfabscheidung nach einem der Ansprüche 1 bis 7, **dadurch gekennzeichnet, dass** das zweite Metall einen niedrigeren Dampfdruck als das reaktive Element hat.

9. Verfahren zur physikalischen Dampfabscheidung nach einem der Ansprüche 1 bis 7, **dadurch gekennzeichnet, dass** das zweite Metall einen höheren Dampfdruck als das reaktive Element hat.

## Revendications

1. Procédé de dépôt physique en phase vapeur comprenant les étapes de :
formation d'au moins un premier et second bains de fusion (114, 115) respectivement de premier et second matériaux différents, dans une chambre de revêtement (122) d'un dispositif de dépôt physique en phase vapeur (120), le premier matériau contenant au moins un premier métal, le second matériau contenant au moins un second métal et au moins un métal réactif présentant une pression de vapeur inférieure à celle du premier métal du premier matériau, le second métal étant associé au métal réactif afin d'amener le second matériau à présenter une température de fusion inférieure à la température de fusion du métal réactif et à présenter une plage de fusion plus étendue que celle du métal réactif ;
maintien d'un article (130) à l'intérieur de la chambre de revêtement (122) ; et
évaporation des premier et second bains de fusion (114, 115) avec un faisceau d'énergie (126) afin de déposer un revêtement (132) sur l'article (130) avec une composition contrôlée qui contient le premier métal et une quantité relativement plus faible du métal réactif.

2. Procédé de dépôt physique en phase vapeur selon la revendication 1, **caractérisé en ce que** le second métal est déposé simultanément avec le premier métal et le métal réactif et le revêtement (132) sur l'article (130) contient les premier et second métaux et le métal réactif.

3. Procédé de dépôt physique en phase vapeur selon la revendication 1, **caractérisé en ce que** le second métal n'est pas déposé simultanément avec le premier métal et le métal réactif et le revêtement (132) sur l'article (130) contient le premier métal et le métal réactif mais est sensiblement exempt du second métal.

4. Procédé de dépôt physique en phase vapeur selon l'une quelconque des revendications 1 à 3, **caractérisé en ce que** le second métal et le métal réactif sont associés comme un alliage sous la forme d'un corps solide (111) qui est délivré dans la chambre de revêtement (122) et fondu avec le faisceau d'énergie (126) afin de former le second bain de fusion (115).

5. Procédé de dépôt physique en phase vapeur selon l'une quelconque des revendications 1 à 3, **caractérisé en ce que** le second métal et le métal réactif sont délivrés dans la chambre de revêtement (122) sous la forme de corps solides distincts (115, 136) qui sont fondus avec le faisceau d'énergie (126) de manière à s'associer et à former le second bain de fusion (115).

6. Procédé de dépôt physique en phase vapeur selon l'une quelconque des revendications 1 à 5, **caractérisé en ce que** le premier matériau est un élément intermétallique à base de bêta-NiAl.

7. Procédé de dépôt physique en phase vapeur selon l'une quelconque des revendications 1 à 6, **caractérisé en ce que** l'élément réactif est au moins un élément choisi à partir du groupe constitué par le zirconium, l'hafnium, l'yttrium et le lanthane.

8. Procédé de dépôt physique en phase vapeur selon l'une quelconque des revendications 1 à 7, **caractérisé en ce que** le second métal présente une pression de vapeur inférieure à celle de l'élément réactif.

9. Procédé de dépôt physique en phase vapeur selon l'une quelconque des revendications 1 à 7, **caractérisé en ce que** le second métal présente une pression de vapeur supérieure à celle de l'élément réactif.
